# EUROPEAN PATENT SPECIFICATION

(11) **EP 3 742 501 B1**
(45) Date of publication and mention of the grant of the patent: **21.12.2022**
(21) Application number: 19756583.1
(22) Date of filing: 19.02.2019
(51) Int. Cl.: H01L 31/0224

(54) **SOLAR CELL AND ELECTRONIC DEVICE PROVIDED WITH SAID SOLAR CELL**
SOLARZELLE UND MIT BESAGTER SOLARZELLE AUSGESTATTETE ELEKTRONISCHE VORRICHTUNG
CELLULE SOLAIRE ET DISPOSITIF ÉLECTRONIQUE MUNI DE LADITE CELLULE SOLAIRE

(30) Priority: 23.02.2018 JP 2018031277
(43) Date of publication of application: 25.11.2020
(73) Proprietor: KANEKA CORPORATION, Osaka 530-8288 (JP)
(72) Inventor: UZU Hisashi, Settsu-shi, Osaka 566-0072 (JP); KOIZUMI Gensuke, Settsu-shi, Osaka 566-0072 (JP)
(74) Representative: V.O.
(86) International application number: PCT/JP2019/006044
(87) International publication number: WO 2019/163751

(56) References cited:
- WO-A1-2016/199501
- WO-A1-2016/199501
- JP-A- 2002 530 894
- JP-A- 2009 283 940
- US-A1- 2002 189 663
- US-A1- 2009 288 702
- US-A1- 2014 166 102
- US-A1- 2014 318 614

## Description

### TECHNICAL FIELD

The present invention relates to a back electrode type (back contact type) (also called back junction type) solar cell and an electronic device including the solar cell.

### BACKGROUND ART

Examples of a solar cell using a semiconductor substrate include a double-sided electrode type solar cell having electrodes formed on both surfaces of a light reception surface and a back surface, and a back electrode type solar cell having electrodes formed only on the back surface. Since such a double-sided electrode type solar cell has electrodes formed on the light reception surface, the electrodes shield sunlight. On the other hand, such a back electrode type solar cell has no electrodes formed on the light reception surface, and thus such a back electrode type solar cell has higher efficiency in receiving sunlight as compared with a double-sided electrode type solar cell. Patent Document 1 discloses a back electrode type solar cell.

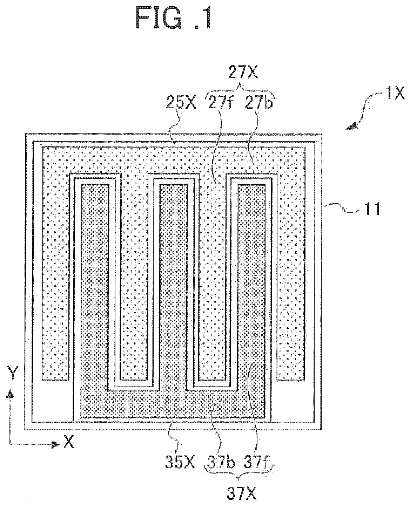

FIG. 1 shows such a conventional back electrode type solar cell as viewed from a back surface side. A solar cell 1X shown in FIG. 1 includes a first conductivity type semiconductor layer 25X and a second conductivity type semiconductor layer 35X formed on a back surface of a semiconductor substrate 11. The first conductivity type semiconductor layer 25X has a so-called comb shape with a plurality of finger parts corresponding to comb teeth and a bus bar part corresponding to a supporting part of the comb teeth. The bus bar part extends in an X direction along one peripheral portion of the semiconductor substrate 11. The finger parts extend from the bus bar part in a Y direction intersecting the X direction. Similarly, the second conductivity type semiconductor layer 35X has a so-called comb shape with a plurality of finger parts corresponding to comb teeth and a bus bar part corresponding to a supporting part of the comb teeth. The bus bar part extends in the X direction along the other peripheral portion facing a peripheral portion of the semiconductor substrate 11. The finger parts extend from the bus bar part in the Y direction. The finger parts of the first conductivity type semiconductor layer 25X and the finger parts of the second conductivity type semiconductor layer 35X are arranged alternately in the X direction. In this way, a forming region of the first conductivity type semiconductor layer 25X and a forming region of the second conductivity type semiconductor layer 35X are in meshing engagement with each other. This structure allows photocarriers induced in the semiconductor substrate 11 in response to incident light from a light reception surface to be collected efficiently at each of the semiconductor layers.

A first electrode layer 27X and a second electrode layer 37X for extracting the collected photocarriers to the outside are provided on the first conductivity type semiconductor layer 25X and the second conductivity type semiconductor layer 35X respectively. The first electrode layer 27X has a so-called comb shape with a plurality of finger parts 27f corresponding to comb teeth and a bus bar part 27b corresponding to a supporting part of the comb teeth. The bus bar part 27b extends in the X direction along one peripheral portion of the semiconductor substrate 11. The finger parts 27f extend from the bus bar part 27b in the Y direction intersecting the X direction. Similarly, the second electrode layer 37X has a so-called comb shape with a plurality of finger parts 37f corresponding to comb teeth and a bus bar part 37b corresponding to a supporting part of the comb teeth. The bus bar part 37b extends in the X direction along the other peripheral portion facing a peripheral portion of the semiconductor substrate 11. The finger parts 37f extend from the bus bar part 37b in the Y direction. The finger parts 27f and the finger parts 37f are arranged alternately in the X direction (see Patent Document 1, for example).

Patent Document 1: Japanese Unexamined Patent Application, Publication No. JP2009200267A.

Document US2009288702A1 discloses a solar cell with trunk electrode layers which form frame electrodes enclosing partitioned regions.

Document WO2016199501A discloses a back-contact solar cell with specific regions not including electrode layers.

### DISCLOSURE OF THE INVENTION

### Problems to be Solved by the Invention

Products of high design quality are required as electronic devices such as wearable devices or wristwatches, and products having a variety of shapes are expected to be designed. Hence, a variety of shapes conforming to the shapes of electronic devices are also considered to be required for products of solar cells to be installed on such electronic devices. In electronic devices such as wearable devices or wristwatches, for example, need is expected to be increased for a solar cell having a specific region such as a through hole for a viewing window at a display part provided at a lower position of a solar cell or a through hole for a hand axis of a wristwatch, for example.

Regarding the conventional back electrode type solar cell 1X shown in FIG. 1, however, formation of a specific region such as a through hole, for example, may separate the finger parts 27f of the first electrode layer 27X. This makes it difficult to extract carriers collected at the first electrode layer 27X, namely, to extract the output of the solar cell 1X.

The present invention is intended to provide a solar cell that facilitates extraction of output even if the solar cell has a specific region, and an electronic device including the solar cell.

### Means for Solving the Problems

A solar cell according to the present invention is a back electrode type solar cell comprising a semiconductor substrate, a first conductivity type semiconductor layer and a second conductivity type semiconductor layer arranged on one of two major surfaces of the semiconductor substrate, a first electrode layer corresponding to the first conductivity type semiconductor layer, and a second electrode layer corresponding to the second conductivity type semiconductor layer. The solar cell comprises a plurality of first specific regions provided at one major surface and not including the first conductivity type semiconductor layer and the second conductivity type semiconductor layer. The solar cell comprises a plurality of partitioned regions formed by partitioning the one major surface into a plurality of regions in such a manner as to enclose corresponding ones of a plurality of the first specific regions. In each of a plurality of the partitioned regions, each of the first electrode layer and the second electrode layer includes a plurality of strip branch electrode layers and a trunk electrode layer to which one end of each of a plurality of the branch electrode layers is connected, some of a plurality of the branch electrode layers of the first electrode layer or the second electrode layer enclose outer edges of at least some of the first specific regions, and the trunk electrode layer of the first electrode layer and/or the trunk electrode layer of the second electrode layer form a frame electrode layer enclosing the partitioned region.

An electronic device according to the present invention includes the solar cell described above.

### Effects of the Invention

According to the present invention, a solar cell that facilitates extraction of output even if the solar cell has a specific region, and an electronic device including the solar cell can be provided.

### BRIEF DESCRIPTION OF THE DRAWINGS

FIG. 1 shows a conventional solar cell as viewed from a back surface side;
FIG. 2 shows a solar cell according to the present embodiment as viewed from a back surface side;
FIG. 3 is a cross-sectional view taken along a line III-III in the solar cell shown in FIG. 2;
FIG. 4 shows a solar cell according to a first modification of the present embodiment as viewed from a back surface side;
FIG. 5 shows a solar cell according to a second modification of the present embodiment as viewed from a back surface side;
FIG. 6 shows a solar cell according to a third modification of the present embodiment as viewed from a back surface side;
FIG. 7 shows a solar cell according to a fourth modification of the present embodiment as viewed from a back surface side; and
FIG. 8 shows a solar cell according to a fifth modification of the present embodiment as viewed from a back surface side.

### PREFERRED MODE FOR CARRYING OUT THE INVENTION

Examples of an embodiment according to the present invention will be described below by referring to the accompanying drawings. It is noted that, in the drawings, the same or corresponding parts are denoted by the same reference numerals. For the sake of convenience, hatching, member reference numerals, etc. may be omitted. However, in such cases, other drawings shall be referred to.

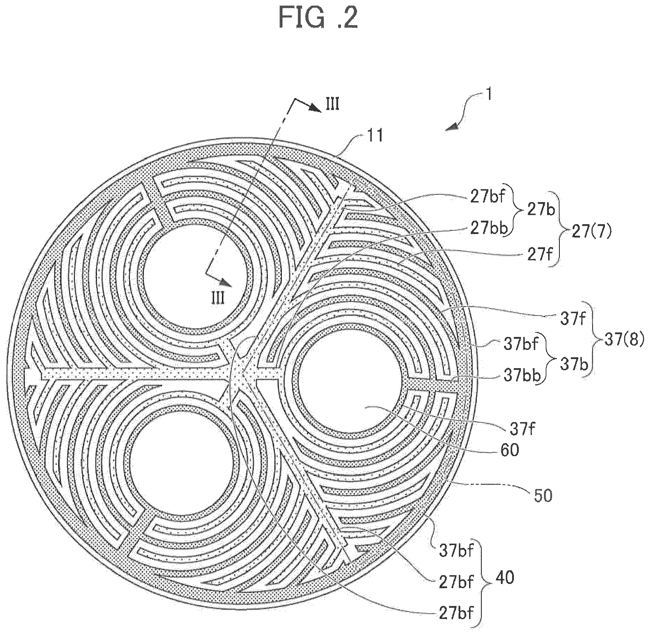

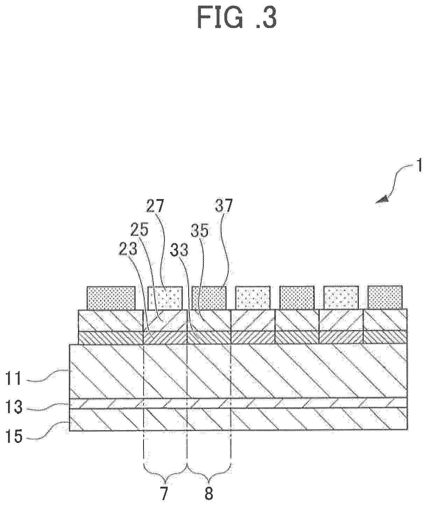

FIG. 2 shows a solar cell according to the present embodiment as viewed from a back surface side. FIG. 3 is a cross-sectional view taken along a line III-III in the solar cell shown in FIG. 2. As shown in FIGS. 2 and 3, a solar cell 1 is a back electrode type (back junction type) solar cell. The solar cell 1 includes a semiconductor substrate 11 having two major surfaces, and includes a first conductivity type region 7 and a second conductivity type region 8 at the major surfaces of the semiconductor substrate 11.

The solar cell 1 includes a passivation layer 13 and an anti-reflective layer 15 sequentially laminated at a major surface on a light reception side that is one of the two major surfaces of the semiconductor substrate 11. The solar cell 1 further includes a passivation layer 23, a first conductivity type semiconductor layer 25, and a first electrode layer 27 sequentially laminated in the first conductivity type region 7 at a back surface corresponding to the other of the major surfaces of the semiconductor substrate 11 on the opposite side of the light reception surface. The solar cell 1 further includes a passivation layer 33, a second conductivity type semiconductor layer 35, and a second electrode layer 37 sequentially laminated in the second conductivity type region 8 at the back surface of the semiconductor substrate 11.

### <Semiconductor substrate>

A conductive single crystal silicon substrate, for example, an n-type single crystal silicon substrate or a p-type single crystal silicon substrate is used as the semiconductor substrate 11. This achieves high photoelectric conversion efficiency. The semiconductor substrate 11 is preferably an n-type single crystal silicon substrate. In an n-type single crystalline silicon substrate, a carrier lifetime is longer. This is because, in a p-type single crystal silicon substrate, light induced degradation (LID) may occur, in which light irradiation affects boron (B), which is a p-type dopant, and thereby a carrier becomes a recombination center. On the other hand, in an n-type single crystal silicon substrate, LID is further suppressed from occurring.

The semiconductor substrate 11 may have a fine uneven structure of a pyramidal shape called a texture structure provided on the back surface that is one of the two major surfaces. This increases efficiency in collecting light having passed through the semiconductor substrate 11 without being absorbed in the semiconductor substrate 11. The semiconductor substrate 11 may have a fine uneven structure of a pyramidal shape called a texture structure provided on the light reception surface. This reduces reflection of incident light on the light reception surface to improve the optical confinement effect in the semiconductor substrate 11.

The thickness of the semiconductor substrate 11 is preferably between 50 and 200 pm inclusive, more preferably between 60 and 180 pm inclusive, and still more preferably between 70 and 180 pm inclusive. Forming the semiconductor substrate 11 into such a small thickness achieves an increase in open-circuit voltage and a reduction in the cost of materials of the solar cell 1. It is noted that, as the semiconductor substrate 11, a conductive polycrystalline silicon substrate may be used, for example, an n-type polycrystalline silicon substrate or a p-type polycrystalline silicon substrate. In this case, a back electrode type solar cell is manufactured at lower costs.

### <Anti-reflective layer>

The anti-reflective layer 15 is formed on the light reception surface of the semiconductor substrate 11 via the passivation layer 13. The passivation layer 13 is formed as an intrinsic silicon-based layer. The passivation layer 13 functions to terminate surface defects of the semiconductor substrate 11 to suppress carrier recombination. A translucent film having a refractive index of approximately 1.5 to 2.3 inclusive is preferably used as the anti-reflective layer 15. As a material of the anti-reflective layer 15, SiO, SiN, or SiON is preferable, for example. While a method of forming the anti-reflective layer 15 is not particularly limited, a chemical vapor deposition (CVD) method achieving precise control of a film thickness is preferably used. Film formation by the CVD method achieves control of film quality by controlling material gas or conditions for the film formation.

In the present embodiment, the light reception surface has no electrodes formed thereon (back electrode type), and such a solar cell has high efficiency in receiving sunlight, and thus the photoelectric conversion efficiency thereof is high.

### <First conductivity type semiconductor layer and second conductivity type semiconductor layer>

The first conductivity type semiconductor layer 25 is formed in the first conductivity type region 7 at the back surface of the semiconductor substrate 11 via the passivation layer 23. The second conductivity type semiconductor layer 35 is formed in the second conductivity type region 8 at the back surface of the semiconductor substrate 11 via the passivation layer 33. The first conductivity type semiconductor layer 25 has a shape conforming to the shape of the first electrode layer 27 described later (see FIG. 2). The second conductivity type semiconductor layer 35 has a shape conforming to the shape of the second electrode layer 37 described later (see FIG. 2).

The first conductivity type semiconductor layer 25 is formed as a first conductivity type silicon-based layer, for example, a p-type silicon-based layer. The second conductivity type semiconductor layer 35 is formed as a silicon-based layer of a second conductivity type different from the first conductivity type, for example, an n-type silicon-based layer. The first conductivity type semiconductor layer 25 may be an n-type silicon-based layer, and the second conductivity type semiconductor layer 35 may be a p-type silicon-based layer. Each of the p-type silicon-based layer and the n-type silicon-based layer is formed of an amorphous silicon layer or a microcrystal silicon layer containing amorphous silicon and crystal silicon. Boron (B) is preferably used as dopant impurities in the p-type silicon-based layer. Phosphorus (P) is preferably used as dopant impurities in the n-type silicon-based layer.

While a method of forming the first conductivity type semiconductor layer 25 and the second conductivity type semiconductor layer 35 is not particularly limited, a CVD method is preferably used. As an example, SiH4 gas is preferably used as a material gas. As an example, hydrogendiluted B2H6 or PH3 is preferably used as a dopant addition gas. A very small quantity of impurities of, for example, oxygen or carbon may be added in order to improve light transmittance. In this case, gas, for example, CO2 or CH4 is introduced during film formation by the CVD method. As a different exemplary method of forming the first conductivity type semiconductor layer 25 and the second conductivity type semiconductor layer 35, a thermal diffusion doping method or a laser doping method is used.

In the back electrode type solar cell, light is received on the light reception surface and generated carriers are collected at the back surface. For this reason, the first conductivity type semiconductor layer 25 and the second conductivity type semiconductor layer 35 are formed in the same plane. A method of forming (patterning) the first conductivity type semiconductor layer 25 and the second conductivity type semiconductor layer 35 into predetermined shapes in the same plane is not particularly limited. A CVD method using a mask may be employed. Alternatively, an etching method using a resist, an etching solution, or etching paste may be employed, for example.

Preferably, the first conductivity type semiconductor layer 25 and the second conductivity type semiconductor layer 35 are not joined. Thus, an insulating layer (not shown) may be provided between these layers. If an insulating layer is provided at a boundary between a p-type silicon-based thin film and an n-type silicon-based thin film, and if the insulating layer is made of silicon oxide, for example, and is formed by a CVD method, a film forming step can be simplified to encourage a reduction in process costs and improvement of yield.

### <Passivation layer>

The passivation layers 23 and 33 are each formed as an intrinsic silicon-based layer. The passivation layers 23 and 33 function to terminate surface defects of the semiconductor substrate 11 to suppress carrier recombination. This extends carrier lifetime to increase the output of the solar cell.

### <First electrode layer and second electrode layer>

The first electrode layer 27 is formed on the first conductivity type semiconductor layer 25. The second electrode layer 37 is formed on the second conductivity type semiconductor layer 35. The first electrode layer 27 and the second electrode layer 37 are isolated (are not connected directly electrically to each other).

The first electrode layer 27 and the second electrode layer 37 may be formed as transparent conductive layers made of a transparent conductive material. As the transparent conductive material, transparent conductive metal oxide is used, for example, indium oxide, tin oxide, zinc oxide, titanium oxide, and complex oxides thereof. From among these, an indium-based complex oxide mainly containing indium oxide is preferably used. An oxide of indium is particularly preferably used, from a viewpoint of high conductivity and transparency. Furthermore, it is preferable to add dopant to an oxide of indium in order to ensure reliability or higher conductivity. Examples of the dopant include Sn, W, Zn, Ti, Ce, Zr, Mo, Al, Ga, Ge, As, Si and S. A method used for forming these transparent electrode layers is a physical vapor deposition method such as a sputtering method or a chemical vapor deposition method (CVD method, for example) using a reaction of an organometallic compound with oxygen or water, for example.

The first electrode layer 27 and the second electrode layer 37 are not limited to the transparent electrode layers but they may include metal electrode layers laminated on the transparent electrode layers. Namely, the first electrode layer and the second electrode layer may be a laminated first electrode layer and a laminated second electrode layer each composed of the laminated transparent electrode layer and metal electrode layer. One of the first electrode layer and the second electrode layer may be a laminated electrode layer and the other may be a single-layer transparent electrode layer. Each of the first electrode layer 27 and the second electrode layer 37 may be formed only of a metal electrode layer. The metal electrode layers are made of a metal material. Examples of the metal material include Cu, Ag, Al, and an alloy of these materials. A printing method such as screen printing using Ag paste, for example, or a plating method such as electrolytic plating using Cu, for example, is employed as a method of forming the metal electrode layers.

Preferably, the width of the first electrode layer 27 is smaller than that of the first conductivity type semiconductor layer 25, and the width of the second electrode layer 37 is smaller than that of the second conductivity type semiconductor layer 35.

To efficiently extract photocarriers collected at the first conductivity type semiconductor layer 25 and the second conductivity type semiconductor layer 35, the first electrode layer 27 and the second electrode layer 37 preferably have largest possible widths relative to the first conductivity type semiconductor layer 25 and the second conductivity type semiconductor layer 35 respectively. Thus, the width of the first electrode layer 27 is preferably greater than 0.5 times, more preferably, greater than 0.7 times the width of the first conductivity type semiconductor layer 25. Likewise, the width of the second electrode layer 37 is preferably greater than 0.5 times, more preferably, greater than 0.7 times the width of the second conductivity type semiconductor layer 35. If an insulating layer or another layer is provided at a boundary between the first conductivity type semiconductor layer 25 and the second conductivity type semiconductor layer 35 so the first electrode layer 27 and the second electrode layer 37 are isolated from each other, the width of the first electrode layer 27 may be greater than that of the first conductivity type semiconductor layer 25, and the width of the second electrode layer 37 may be greater than that of the second conductivity type semiconductor layer 35.

On the other hand, to efficiently collect photocarriers in the semiconductor substrate 11 using the first conductivity type semiconductor layer 25 and the second conductivity type semiconductor layer 35, the respective widths of the first electrode layer 27 (first branch electrode layer 27f and first trunk electrode layer 27b described later) and the second electrode layer 37 (second branch electrode layer 37f and second trunk electrode layer 37b described later) preferably have some certain degree of smallness. While the respective widths of the first branch electrode layer 27f and the second branch electrode layer 37f, and those of the first conductivity type semiconductor layer 25 and the second conductivity type semiconductor layer 35 corresponding to the respective branch electrodes are not particularly limited as long as they have some certain degree of smallness, these widths are preferably in a range between 50 and 3000 pm inclusive. Unless otherwise specified, the widths of a conductive layer and an electrode layer are defined in directions orthogonal to directions of their extensions. On the other hand, from a viewpoint of electricity transport, a trunk electrode layer requires a certain degree of cross-sectional area for reducing electrical resistance loss, and the cross-sectional area is required to be ensured using the width and height of the trunk electrode layer. In this regard, the respective widths of the first trunk electrode layer 27b and the second trunk electrode layer 37b, and those of the first conductivity type semiconductor layer 25 and the second conductivity type semiconductor layer 35 corresponding to the respective trunk electrode layers are preferably in a range between 50 and 5000 pm inclusive.

Increasing the respective heights of the first electrode layer 27 and the second electrode layer 37 increases a cross-sectional area for a current to flow in a plane direction, thereby reducing series resistance. However, increasing the height of an electrode layer increases stress at an interface between a semiconductor layer and the electrode layer, and this may cause detachment of an electrode. Moreover, in a back electrode type solar cell in which an electrode is provided only on one surface, increasing the height of an electrode layer causes a stress unbalance between the front and back of a substrate. In this case, deformation such as deflection of the solar cell is likely to occur, and this may cause breakage of the solar cell. If the solar cell is deformed by stress at an electrode interface, trouble such as misalignment or short-circuit may occur during configuration of the solar cell as a module. For this reason, the respective heights of the first electrode layer 27 and the second electrode layer 37 are preferably equal to or less than 100 µm, more preferably, equal to or less than 60 µm, and still more preferably, equal to or less than 30 pm. The height of an electrode is a distance from a major surface of a substrate to the top of the electrode. In the presence of a region of the substrate where a thickness is reduced partially by etching for forming a semiconductor layer, for example, a reference plane parallel to the major surface of the substrate may be defined, and a distance from the reference plane to the top of the electrode may be defined as the height of the electrode.

### <First specific region>

In the solar cell 1, a plurality of first specific regions 60 is formed at a major surface of the semiconductor substrate 11. In the solar cell 1 according to the present embodiment shown in FIG. 2, three first specific regions 60 are formed. The first specific region 60 is a region not including the first electrode layer 27 and the second electrode layer 37. The first specific region 60 may include the passivation layer 23 and the first conductivity type semiconductor layer 25, and the passivation layer 33 and the second conductivity type semiconductor layer 35. In an electronic device such as a wearable device or a wristwatch, for example, the first specific region 60 is a through hole for a viewing window at a display part provided at a lower position of the solar cell or a through hole for a hand axis of a wristwatch. Alternatively, the first specific region 60 may be a region provided at the semiconductor substrate 11 and having a material of higher resistance than the first electrode layer 27 and the second electrode layer 37.

The first specific region 60 has a circular shape, for example, in a plan view of the major surface of the semiconductor substrate 11. However, this is not the only shape of the first specific region 60 but the first specific region 60 may have a strip shape or a polygonal shape (a triangular shape or a rectangular shape, for example). A plurality of the first specific regions 60 are formed in the semiconductor substrate 11. In the presence of a plurality of the first specific regions 60, these first specific regions 60 may have the same area or different areas.

The first specific region 60 has an outer edge enclosed by the second branch electrode layer 37f (or first branch electrode layer 27f) of the second electrode layer 37 (or first electrode layer 27) described later.

### <Partitioned region>

The solar cell 1 has three partitioned regions 50 formed by partitioning the major surface of the semiconductor substrate 11 into three regions in such a manner as to enclose corresponding ones of three first specific regions 60. One first specific region 60 is provided in the partitioned region 50 to reduce the occurrence of separation of the first branch electrode layer 27f and the second branch electrode layer 37f by the first specific region 60 described later.

### <Details of first electrode layer and second electrode layer>

The first electrode layer 27 and the second electrode layer 37 are preferably formed to be distributed in all regions in the major surface of the semiconductor substrate 11 except the first specific region 60. This increases an effective power generation area to increase photoelectric conversion efficiency. In each partitioned region 50, the first electrode layer 27 includes a plurality of first branch electrode layers 27f and first trunk electrode layers 27b. In each partitioned region 50, the second electrode layer 37 includes a plurality of second branch electrode layers 37f and second trunk electrode layers 37b.

### «First branch electrode layer and second branch electrode layer»

The first branch electrode layer 27f and the second branch electrode layer 37f are so-called finger electrodes and have shapes like strips (strip shapes). The first branch electrode layer 27f and the second branch electrode layer 37f may have linear shapes or curved shapes. Electrode patterns of the first branch electrode layer 27f and the second branch electrode layer 37f are not particularly limited. In each partitioned region 50 except regions for forming the first specific region 60, the first trunk electrode layer 27b, and the second trunk electrode layer 37b, each of the first branch electrode layer 27f and the second branch electrode layer 37f preferably has a pattern concentric with the semiconductor substrate 11, for example. In other words, each of the first branch electrode layer 27f and the second branch electrode layer 37f is preferably formed to be centered on the center of the first specific region 60 and to overlap a similar figure of the first specific region 60. This prevents disconnection of the branch electrode layer resulting from the first specific region 60 that may be a through hole or a high-resistance region, for example, thereby preventing the branch electrode layer from being disconnected from the trunk electrode layer and thus being isolated electrically. As a result, carriers collected at a plurality of branch electrode layers are collected via the trunk electrode layer, namely, the output of the solar cell 1 is increased.

With the first branch electrode layer 27f and the second branch electrode layer 37f formed in such a manner as to overlap a similar figure of the first specific region 60 and in the presence of a through hole in the first specific region 60, for example, even if deflection is to be caused at the semiconductor substrate 11 by the formation of the branch electrode layers, these branch electrode layers can be formed symmetrically with respect to the through hole as the first specific region 60. By doing so, uniform stress is applied to the semiconductor substrate 11 around the through hole. This reduces the occurrence of fractures of the semiconductor substrate 11 starting from the through hole, and this is expected to improve yield during manufacture and thus reduce manufacturing costs.

In terms of a local range, it is preferable that the first branch electrode layer 27f and the second branch electrode layer 37f be locally aligned in parallel by being arranged alternately in a direction vertical to a direction in which the first branch electrode layer 27f and the second branch electrode layer 37f extend (a direction vertical to a tangent to each point, for example).

The outer edges of the first specific regions 60 are enclosed by either some of the first branch electrode layers 27f or some of the second branch electrode layers 37f. The branch electrode layer enclosing the outer edge of the first specific region 60 may either be the first branch electrode layer 27f or the second branch electrode layer 37f. In the solar cell 1 according to the present embodiment, the outer edges of the first specific regions 60 are enclosed by some of the second branch electrode layers 37f. The branch electrode enclosing the outer edge of the first specific region 60 may have an annular shape (closed ring-like shape) or an open ring-like shape. This annular shape or open ring-like shape of the branch electrode may be a curved shape or a linear shape.

In each partitioned region 50, one end of the first branch electrode layer 27f is connected to the first trunk electrode layer 27b and the other end of the first branch electrode layer 27f is isolated from the second trunk electrode layer 37b. Further, one end of the second branch electrode layer 37f is connected to the second trunk electrode layer 37b and the other end of the second branch electrode layer 37f is isolated from the first trunk electrode layer 27b.

### «First trunk electrode layer and second trunk electrode layer»

Each of the first trunk electrode layer 27b and the second trunk electrode layer 37b is a so-called bus bar electrode, and has a shape like a strip (strip shape). Each of the first trunk electrode layer 27b and the second trunk electrode layer 37b may have a linear shape or a curved shape. In each partitioned region 50, the first trunk electrode layer 27b includes a first frame trunk electrode layer 27bf and a first strip trunk electrode layer 27bb. In each partitioned region 50, the second trunk electrode layer 37b includes a second frame trunk electrode layer 37bf and a second strip trunk electrode layer 37bb.

### «<First frame trunk electrode layer, second frame trunk electrode layer, and frame electrode layer»>

The first frame trunk electrode layer 27bf and the second frame trunk electrode layer 37bf form a frame electrode layer 40. The frame electrode layer 40 is formed to enclose each partitioned region 50, in other words, to overlap an outer edge of the partitioned region 50. The frame electrode layer 40 may have an open ring-like shape in which the first frame trunk electrode layer 27bf and the second frame trunk electrode layer 37bf are isolated from each other. Like in a modification described later, the frame electrode layer 40 may have an annular shape (closed ring-like shape) formed only of the first frame trunk electrode layer 27bf or the second frame trunk electrode layer 37bf. This annular shape or open ring-like shape of the frame electrode layer 40 may be a curved shape or a linear shape.

Preferably, the frame electrode layer 40 includes both the first frame trunk electrode layer 27bf of the first electrode layer 27 and the second frame trunk electrode layer 37bf of the second electrode layer 37. In the example shown in Fig. 2, the frame electrode layer 40 includes the second frame trunk electrode layer 37bf formed at the periphery of the semiconductor substrate 11, and the first frame trunk electrode layer 27bf formed at a boundary between adjacent partitioned regions. This makes it unlikely that the first branch electrode layer 27f and the second branch electrode layer 37f will be disconnected from the trunk electrodes and thus will be isolated electrically to collect output of the solar cell 1 in the entire partitioned region 50. Namely, the output of the solar cell 1 is increased.

As a result of the presence of a part of the frame electrode layer 40 formed at a boundary between adjacent partitioned regions, even if different branch electrode layer patterns are formed in respective partitioned regions, the branch electrode layer patterns are not required to be connected at the boundary. In this way, as a result of the presence of a part of the frame electrode layer 40 arranged at the boundary between the adjacent partitioned regions, a branch electrode layer of an optional pattern is connected to the frame electrode layer 40. As a result, carriers collected at a branch electrode layer having a high degree of optionality are collected at the frame electrode layer 40 at the boundary, thereby collecting the output of the solar cell 1 efficiently.

Increasing the length of a branch electrode layer, which is smaller in width and higher in electrical resistance than a trunk electrode layer, increases resistance loss. In this regard, according to the present embodiment, a trunk electrode layer is arranged between adjacent partitioned regions 50 and the branch electrode layer is connected to this trunk electrode layer. This makes it possible to reduce the length of the branch electrode layer compared to a length in the absence of a trunk electrode layer, thereby reducing electrical resistance loss. Namely, the output of the solar cell 1 is increased.

The frame electrode layer 40 is further formed along the periphery of the semiconductor substrate 11. Thus, even with the shape of the semiconductor substrate 11 having a relatively high degree of optionality, carriers collected at the branch electrode layer in the partitioned region 50 can still be collected at the frame electrode layer along the periphery of the semiconductor substrate 11. In this way, the output of the solar cell 1 is collected efficiently. Namely, the output of the solar cell 1 is increased.

As described above, the shape of the first specific region 60 or the branch electrode layer is given an increased degree of optionality. In terms of installation on an electronic device for wearable purposes (a wristwatch, a smart watch, or a sensor), the design of the shape of a solar cell is given an increased degree of optionality and the output of the solar cell 1 is increased efficiently.

### «<First strip trunk electrode layer and second strip trunk electrode»>

The first strip trunk electrode layer 27bb has a strip shape extending from the first frame trunk electrode layer 27bf of the frame electrode layer 40 toward the first specific region 60. The second strip trunk electrode layer 37bb has a strip shape extending from the second frame trunk electrode layer 37bf of the frame electrode layer 40 toward the first specific region 60. Each of the first strip trunk electrode layer 27bb and the second strip trunk electrode layer 37bb may have a linear shape or a curved shape.

A plurality of the first branch electrode layers 27f are connected to the first frame trunk electrode layer 27bf of the frame electrode layer 40 and to the first strip trunk electrode layer 27bb. A plurality of the second branch electrode layers 37f are connected to the second frame trunk electrode layer 37bf of the frame electrode layer 40 and to the second strip trunk electrode layer 37bb. This prevents disconnection of the branch electrode layer resulting from the first specific region 60 that may be a through hole or a high-resistance region, for example, thereby preventing the first branch electrode layer 27f and the second branch electrode layer 37f from being disconnected from the first trunk electrode layer 27b and to the second trunk electrode layer 37b respectively and thus being isolated electrically. As a result, carriers collected at a plurality of the first branch electrode layers 27f and at a plurality of the second branch electrode layers 37f are collected via the first trunk electrode layer 27b (frame electrode layer 40, first strip trunk electrode layer 27bb), namely, the output of the solar cell 1 is increased.

The back electrode type solar cell according to the present embodiment is preferably employed in an electronic device mainly used in a lowilluminance environment, particularly for wearable purposes (a wristwatch, a smart watch, or a sensor), etc. In this case, the intensity of light generally emitted is low and electrical resistance loss is not serious compared to that in a solar cell panel. For this reason, forming an extraction electrode and an extraction electrode functioning as an anode and a cathode (not shown) at a part of the first trunk electrode layer 27b and the second trunk electrode layer 37b respectively facilitates extraction of collected carriers. The extraction electrodes are formed by a method that may be a printing method such as screen printing using Ag paste, for example, or a plating method such as electrolytic plating using Cu, for example. Alternatively, the extraction electrodes may be formed by soldering, for example.

### (First modification)

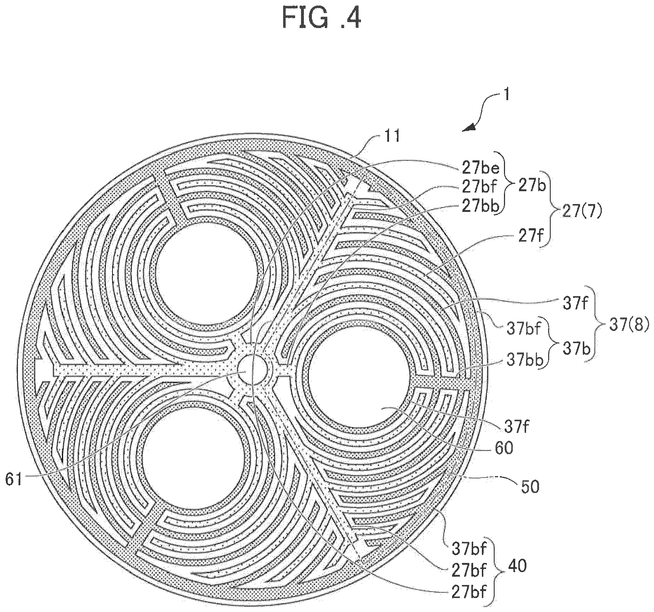

FIG. 4 shows a solar cell according to a first modification of the present embodiment as viewed from a back surface side. A solar cell 1 shown in FIG. 4 differs from the present embodiment in that the solar cell 1 shown in FIG. 2 further includes a second specific region 61. The second specific region 61 is a region not including the first electrode layer 27 and the second electrode layer 37. The second specific region 61 may include the passivation layer 23 and the first conductivity type semiconductor layer 25, and the passivation layer 33 and the second conductivity type semiconductor layer 35. In an electronic device such as a wearable device or a wristwatch, for example, the second specific region 61 is a through hole for a viewing window at a display part provided at a lower position of the solar cell or a through hole for a hand axis of a wristwatch. Alternatively, the second specific region 61 may be a region provided at the semiconductor substrate 11 and having a material of higher resistance than the first electrode layer 27 and the second electrode layer 37. The second specific region 61 has a circular shape, for example, in a plan view of the major surface of the semiconductor substrate 11. However, this is not the only shape of the second specific region 61, but the second specific region 61 may have a strip shape or a polygonal shape (a triangular shape or a rectangular shape, for example). A plurality of the second specific regions 61 or one second specific region 61 may be formed in the semiconductor substrate 11. A plurality of the second specific regions 61 may have the same area or different areas. A plurality of the first specific regions 60 may have the same area or different areas. The second specific region 61 has an outer edge enclosed by a first enclosing trunk electrode layer 27be (or second enclosing trunk electrode layer 37be) of the first electrode layer 27 (or second electrode layer 37) described later.

The second specific region 61 is preferably formed at a position corresponding to a boundary between two or more partitioned regions 50 such as the center of the semiconductor substrate 11. If the second specific region 61 has a small size, for example, the second specific region 61 is preferably formed in the partitioned region 50. In response to a design, etc., a specific region as a through hole, for example, may be the first specific region 60 or the second specific region 61.

The first trunk electrode layer 27b further includes the first enclosing trunk electrode layer 27be, and the first enclosing trunk electrode layer 27be is formed to enclose the second specific region 61. The first enclosing trunk electrode layer 27be may have an annular shape (closed ring-like shape) or an open ring-like shape. The first enclosing trunk electrode layer 27be may have a curved shape or a linear shape. The first enclosing trunk electrode layer 27be may have a circular shape or a polygonal shape. The first strip trunk electrode layer 27bb of the first trunk electrode layer 27b extends from the first enclosing trunk electrode layer 27be toward the first specific region 60.

### (Second modification)

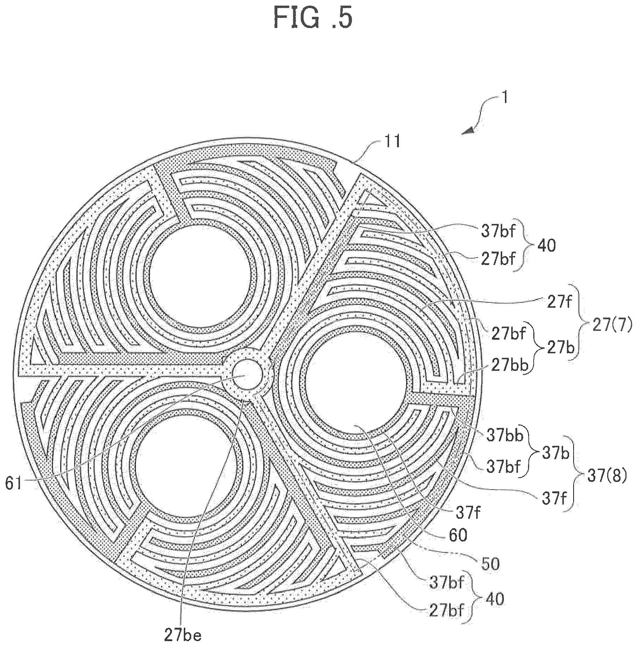

FIG. 5 shows a solar cell according to a second modification of the present embodiment as viewed from a back surface side. A solar cell 1 shown in FIG. 5 differs from the solar cell 1 shown in FIG. 2 in that the solar cell 1 further includes the second specific region 61 described above, the frame electrode layers 40 are adjacent to each other at a boundary between adjacent partitioned regions 50, and the first frame trunk electrode layer 27bf and the second frame trunk electrode layer 37bf are provided along the periphery of the semiconductor substrate 11 within the partitioned region 50. The first strip trunk electrode layer 27bb and the second strip trunk electrode layer 37bb are also adjacent to each other. In the present embodiment shown in FIG. 2, the first frame trunk electrode layer 27bf at a boundary between adjacent partitioned regions 50 is shared between these partitioned regions 50. By contrast, according to the second modification, the first frame trunk electrode layer 27bf or the second frame trunk electrode layer 37bf is formed for each partitioned region 50. This allows design of an electrode pattern in the partitioned region 50 independently of a different adjacent partitioned region, for example.

### (Third modification)

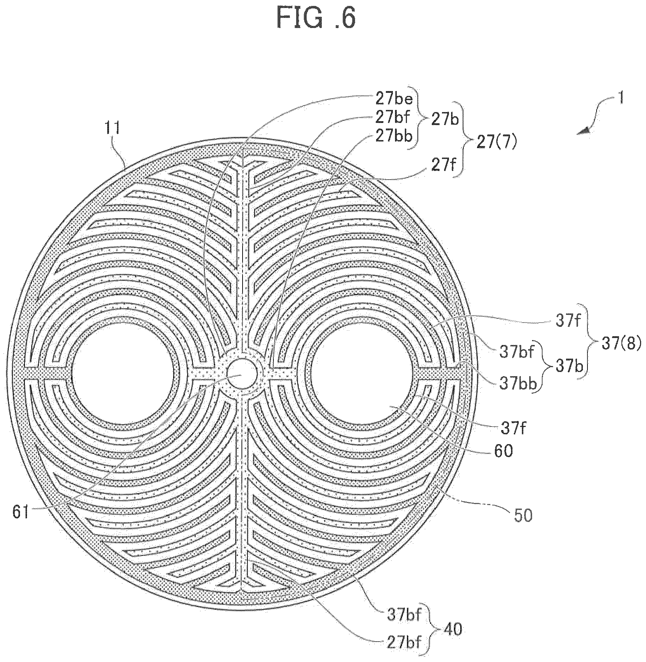

FIG. 6 shows a solar cell according to a third modification of the present embodiment as viewed from a back surface side. A solar cell 1 shown in FIG. 6 differs from the present embodiment in that the solar cell 1 shown in FIG. 2 further includes the second specific region 61 described above, and the first specific region 60 and the second specific region 61 are arranged in a line, for example. Unlike the specific region 60 enclosed by the second branch electrode layer 37f, the second specific region 61 is enclosed by a trunk electrode layer (frame electrode layer) to which a plurality of branch electrode layers is connected.

### (Fourth modification)

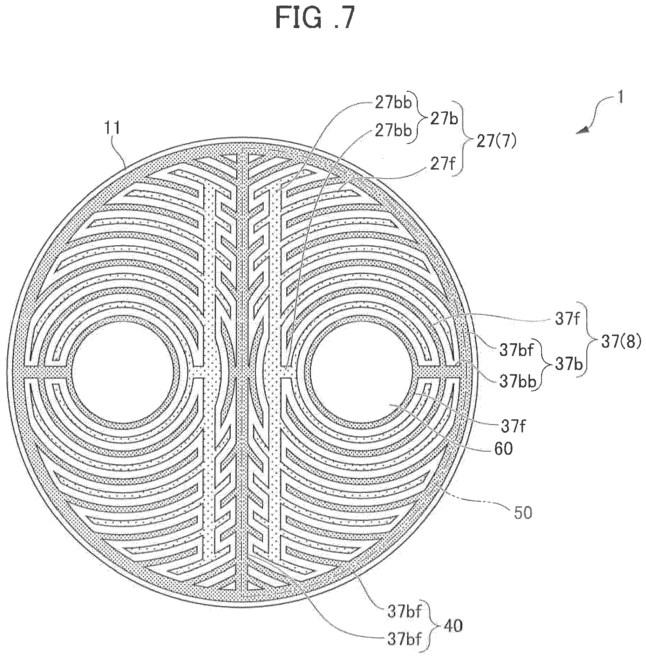

FIG. 7 shows a solar cell according to a fourth modification of the present embodiment as viewed from a back surface side. A solar cell 1 shown in FIG. 7 differs from the present embodiment in that the frame electrode layer 40 is formed only of the second frame trunk electrode layer 37bf (or first frame trunk electrode layer 27bf), and the frame electrode layer 40 has an annular shape (closed ring-like shape). In this case, the first trunk electrode layer 27b may include only the first strip trunk electrode layer 27bb. According to the fourth modification, the first trunk electrode layer 27b includes two first strip trunk electrode layers 27bb. One of the first strip trunk electrode layers 27bb has a strip shape extending in each partitioned region 50, namely, in a region enclosed by the frame electrode layer 40 (second frame trunk electrode layer 37bf) in such a manner as not to intersect the first specific region 60 and as to intersect the first branch electrode layer 27f. The other of the first strip trunk electrode layers 27bb has a strip shape extending from one first strip trunk electrode layer 27bb toward the first specific region 60.

### (Fifth modification)

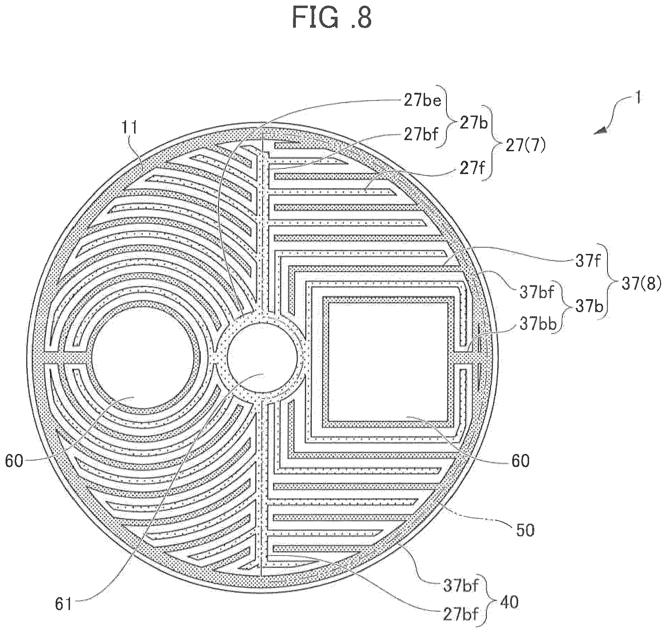

FIG. 8 shows a solar cell according to a fifth modification of the present embodiment as viewed from a back surface side. A solar cell 1 shown in FIG. 8 differs from the present embodiment in that the solar cell 1 shown in FIG. 2 further includes the second specific region 61 described above, the first specific region 60 and the second specific region 61 are arranged in a line, for example, and a plurality of first specific regions have different shapes. The solar cell 1 shown in FIG. 8 includes a circular first specific region 60 and a rectangular first specific region 60. In this case, the shapes of branch electrode layers in corresponding partitioned regions 50 are not symmetrical with respect to a boundary between these partitioned region 50. In this solar cell 1, however, as a result of the presence of the first frame trunk electrode layer 27bf formed at a boundary between partitioned regions, carriers collected at a branch electrode layer can be collected efficiently to collect the output of the solar cell 1 efficiently.

### (Electronic device)

For actual use of the solar cell 1 according to the present embodiment, the solar cell 1 is preferably configured as a module. The solar cell is configured as a module by an appropriate method. For example, a wire or a contact pin may be connected to the trunk electrode layers 27b and 37b functioning as an anode and a cathode or to extraction electrodes (not shown) at the corresponding electrode layers to allow extraction of electricity. A back electrode type solar cell is configured as a module by being sealed with a sealing agent and a glass plate. The solar cell configured as a module in this way becomes installable on an electronic device for wearable purposes (a wristwatch, a smart watch, or a sensor).

While the embodiment according to the present invention has been described so far, the present invention is not limited to the above-described embodiment, and various modifications are available. In the present embodiment described above, the heterojunction type solar cell has been described. In an example, the features of the present invention may be applied to various types of solar cells such as a homojunction type solar cell, and are not limited to such a heterojunction type solar cell.

The back electrode type solar cell 1 shown as an example in the present embodiment described above includes the passivation layer 23, the first conductivity type semiconductor layer 25, and the first electrode layer 27 sequentially laminated in the first conductivity type region 7 at the back surface of the semiconductor substrate 11, and the passivation layer 33, the second conductivity type semiconductor layer 35, and the second electrode layer 37 sequentially laminated in the second conductivity type region 8 at the back surface of the semiconductor substrate 11 excepting the first conductivity type region 7. However, the present invention is not limited to this solar cell 1 but may also be a back electrode type solar cell in which at least a part of a first conductivity type semiconductor layer and at least a part of a second conductivity type semiconductor layer overlap each other. This solar cell may be realized by forming the first electrode layer corresponding to the first conductivity type semiconductor layer using the first branch electrode layer and the first trunk electrode layer (frame electrode layer and/or first strip trunk electrode layer) described above, and by forming the second electrode layer corresponding to the second conductivity type semiconductor layer using the second branch electrode layer and the second trunk electrode layer (frame electrode layer and/or second strip trunk electrode layer) described above.

### EXPLANATION OF REFERENCE NUMERALS

1, 1X Solar cell
7 First conductivity type region
8 Second conductivity type region
11 Semiconductor substrate
13, 23, 33 Passivation layer
15 Anti-reflective layer
25, 25X First conductivity type semiconductor layer
27, 27X First electrode layer
27b First trunk electrode layer (bus bar electrode, bus bar part)
27bb First strip trunk electrode layer
27be First enclosing trunk electrode layer
27bf First frame trunk electrode layer
27f First branch electrode layer (finger electrode, finger part)
35, 35X Second conductivity type semiconductor layer
37, 37X Second electrode layer
37b Second trunk electrode layer (bus bar electrode, bus bar part)
37bb Second strip trunk electrode layer
37be Second enclosing trunk electrode layer
37bf Second frame trunk electrode layer
37f Second branch electrode layer (finger electrode, finger part)
40 Frame electrode layer
50 Partitioned region
60 Through hole (first specific region)
61 Through hole (second specific region)

## Claims

1. A back electrode type solar cell (1) comprising a semiconductor substrate (11), a first conductivity type semiconductor layer (25) and a second conductivity type semiconductor layer (35) arranged on one of two major surfaces of the semiconductor substrate (11), a first electrode layer (27) corresponding to the first conductivity type semiconductor layer (25), and a second electrode layer (37) corresponding to the second conductivity type semiconductor layer (35), wherein
the solar cell (1) comprises a plurality of first specific regions (60) provided at the one major surface and not including the first electrode layer (27) and the second electrode layer (37),
the solar cell (1) comprises a plurality of partitioned regions (50) formed by partitioning the one major surface into a plurality of regions in such a manner as to enclose corresponding ones of a plurality of the first specific regions (60),
in each of a plurality of the partitioned regions (50),
each of the first electrode layer (27) and the second electrode layer (37) includes a plurality of strip branch electrode layers and a trunk electrode layer (27b, 37b) to which one end of each of a plurality of the branch electrode layers is connected,
some of a plurality of the branch electrode layers of the first electrode layer (27) or the second electrode layer (37) enclose outer edges of at least some of the first specific regions (60), and
the trunk electrode layer (27b) of the first electrode layer (27) and/or the trunk electrode layer (37b) of the second electrode layer (37) form a frame electrode layer (40) at least partially enclosing the partitioned region (50).

2. The solar cell according to claim 1, wherein the frame electrode layer (40) has an annular shape or an open ring-like shape.

3. The solar cell according to claim 2, wherein the frame electrode layer (40) has at least one portion with a curved shape and at least one portion with a linear shape.

4. The solar cell according to any one of claims 1 to 3, wherein at least one of the trunk electrode layer (27b) of the first electrode layer (27) and the trunk electrode layer (37b) of the second electrode layer (27) includes a strip trunk electrode layer (27bb, 37bb) extending from the frame electrode layer (40).

5. The solar cell according to claim 4, wherein the strip trunk electrode layer (27bb) of the first electrode layer (27) and the strip trunk electrode layer (37bb) of the second electrode layer (37) are adjacent to each other.

6. The solar cell according to any one of claims 1 to 5, wherein the trunk electrode layer (27b, 37b) of the first electrode layer (27) or the second electrode layer (37) includes a strip trunk electrode layer (37bb) arranged inside the frame electrode layer (40).

7. The solar cell according to claim 6 wherein the strip trunk electrode layer (27bb, 37bb) is coupled to the branch electrode layer (27f) enclosing the outer edge of the first specific region (60).

8. The solar cell according to any one of claims 1 to 7, comprising a second specific region (61) provided at the one major surface and not including the first electrode layer (27) and the second electrode layer (37), wherein
the trunk electrode layer (27b) of the first electrode layer (27) includes an enclosing trunk electrode layer (27be) enclosing an outer edge of the second specific region (61), and a strip trunk electrode layer (27bb) extending from the enclosing trunk electrode layer (27be).

9. The solar cell according to any one of claims 1 to 8, wherein the first specific region (60) is a through hole or has a material of higher resistance than the first electrode layer (27) and the second electrode layer (37).

10. The solar cell according to claim 8 wherein the second specific region (61) is a through hole or has a material of higher resistance than the first electrode layer (27) and the second electrode layer (37).

11. The solar cell according to any one of claims 1 to 10 wherein in a region in the partitioned region (50) and excepting the trunk electrode layer (27b, 37b) and the first specific region (60), the branch electrode layer (27f, 37f) is formed to be centered on the center of the first specific region (60) and to overlap a similar figure of the first specific region (60).

12. An electronic device comprising the solar cell according to any one of claims 1 to 11.

## Patentansprüche

1. Rückelektroden-Solarzelle (1) mit einem Halbleitersubstrat (11), einer ersten leitfähigen Halbleiterschicht (25) und einer zweiten leitfähigen Halbleiterschicht (35), die auf einer der beiden Hauptoberflächen des Halbleitersubstrats (11) angeordnet sind, einer ersten Elektrodenschicht (27), die der ersten leitfähigen Halbleiterschicht (25) entspricht, und einer zweiten Elektrodenschicht (37), die der zweiten leitfähigen Halbleiterschicht (35) entspricht, wobei
die Solarzelle (1) mehrere erste spezifische Bereiche (60) umfasst, die an der einen Hauptoberfläche bereitgestellt sind und die erste Elektrodenschicht (27) und die zweite Elektrodenschicht (37) nicht einschließen,
die Solarzelle (1) mehrere unterteilte Bereiche (50) umfasst, die durch Unterteilung der einen Hauptoberfläche in mehrere Bereiche so gebildet sind, dass sie entsprechende mehrerer erster spezifischer Bereiche (60) umschließen,
in jedem von mehreren unterteilten Bereichen (50),
jeweils die erste Elektrodenschicht (27) und die zweite Elektrodenschicht (37) mehrere Streifen-Zweigelektrodenschichten und eine Stammelektrodenschicht (27b, 37b) einschließt, mit der ein Ende jeder mehrerer Zweigelektrodenschichten verbunden ist,
einige mehrerer Zweigelektrodenschichten der ersten Elektrodenschicht (27) oder der zweiten Elektrodenschicht (37) äußere Kanten von wenigstens einigen der ersten spezifischen Bereiche (60) umschließen, und
die Stammelektrodenschicht (27b) der ersten Elektrodenschicht (27) und/oder die Stammelektrodenschicht (37b) der zweiten Elektrodenschicht (37) eine Rahmenelektrodenschicht (40) bilden, die den unterteilten Bereich (50) wenigstens teilweise umschließt.

2. Solarzelle nach Anspruch 1, wobei die Rahmenelektrodenschicht (40) eine ringförmige Form oder eine offene ringähnliche Form aufweist.

3. Solarzelle nach Anspruch 2, wobei die Rahmenelektrodenschicht (40) wenigstens einen Abschnitt mit einer gekrümmten Form und wenigstens einen Abschnitt mit einer linearen Form aufweist.

4. Solarzelle nach einem der Ansprüche 1 bis 3, wobei wenigstens die Stammelektrodenschicht (27b) der ersten Elektrodenschicht (27) und/oder die Stammelektrodenschicht (37b) der zweiten Elektrodenschicht (27) eine Streifen-Stammelektrodenschicht (27bb, 37bb) einschließt, die sich von der Rahmenelektrodenschicht (40) aus erstreckt.

5. Solarzelle nach Anspruch 4, wobei die Streifen-Stammelektrodenschicht (27bb) der ersten Elektrodenschicht (27) und die Streifen-Stammelektrodenschicht (37bb) der zweiten Elektrodenschicht (37) einander benachbart sind.

6. Solarzelle nach einem der Ansprüche 1 bis 5, wobei die Stammelektrodenschicht (27b, 37b) der ersten Elektrodenschicht (27) oder der zweiten Elektrodenschicht (37) eine Streifen-Stammelektrodenschicht (37bb) einschließt, die innerhalb der Rahmenelektrodenschicht (40) angeordnet ist.

7. Solarzelle nach Anspruch 6, wobei die Streifen-Stammelektrodenschicht (27bb, 37bb) mit der Zweigelektrodenschicht (27f) gekoppelt ist, die die Außenkante des ersten spezifischen Bereichs (60) umschließt.

8. Solarzelle nach einem der Ansprüche 1 bis 7, die einen zweiten spezifischen Bereich (61) umfasst, der an der einen Hauptoberfläche bereitgestellt ist und die erste Elektrodenschicht (27) und die zweite Elektrodenschicht (37) nicht einschließt, wobei
die Stammelektrodenschicht (27b) der ersten Elektrodenschicht (27) eine umschließende Stammelektrodenschicht (27be), die eine Außenkante des zweiten spezifischen Bereichs (61) einschließt, und eine Streifen-Stammelektrodenschicht (27bb), die sich von der umschließenden Stammelektrodenschicht (27be) erstreckt, einschließt.

9. Solarzelle nach einem der Ansprüche 1 bis 8, wobei der erste spezifische Bereich (60) ein Durchgangsloch ist oder ein Material mit höherem Widerstand als die erste Elektrodenschicht (27) und die zweite Elektrodenschicht (37) aufweist.

10. Solarzelle nach Anspruch 8, wobei der zweite spezifische Bereich (61) ein Durchgangsloch ist oder ein Material mit höherem Widerstand als die erste Elektrodenschicht (27) und die zweite Elektrodenschicht (37) aufweist.

11. Solarzelle nach einem der Ansprüche 1 bis 10, wobei in einem Bereich in dem unterteilten Bereich (50) und mit Ausnahme der Stammelektrodenschicht (27b, 37b) und des ersten spezifischen Bereichs (60) die Zweigelektrodenschicht (27f, 37f) so ausgebildet ist, dass sie in der Mitte des ersten spezifischen Bereichs (60) zentriert ist und eine ähnliche Figur des ersten spezifischen Bereichs (60) überlappt.

12. Elektronische Vorrichtung mit einer Solarzelle nach einem der Ansprüche 1 bis 11.

## Revendications

1. Cellule solaire du type à contre-électrode (1) comprenant un substrat semi-conducteur (11), une couche semi-conductrice du premier type de conductivité (25) et une couche semi-conductrice du deuxième type de conductivité (35) agencées sur l'une des deux surfaces principales du substrat semi-conducteur (11), une première couche d'électrode (27) correspondant à la couche semi-conductrice du premier type de conductivité (25), et une deuxième couche d'électrode (37) correspondant à la couche semi-conductrice du deuxième type de conductivité (35), dans lequel
la cellule solaire (1) comprend une pluralité de premières régions spécifiques (60) disposées sur la surface principale et n'incluant pas la première couche d'électrode (27) et la deuxième couche d'électrode (37),
la cellule solaire (1) comprend une pluralité de régions cloisonnées (50) formées en divisant la première surface principale en une pluralité de régions de manière à enfermer celles correspondantes d'une pluralité de premières régions spécifiques (60),
dans chacune d'une pluralité de régions cloisonnées (50),
chacune parmi la première couche d'électrode (27) et la deuxième couche d'électrode (37) comprennent une pluralité de couches d'électrodes de branche sous forme de bande et une couche d'électrode principale (27b, 37b) à laquelle une extrémité de chacune d'une pluralité de couches d'électrode de branche est connectée,
certaines d'une pluralité de couches d'électrodes de branche de la première couche d'électrode (27) ou de la deuxième couche d'électrode (37) renferment des bords externes d'au moins certaines des premières régions spécifiques (60), et
la couche d'électrode principale (27b) de la première électrode (27) et/ou la couche d'électrode principale (37b) de la deuxième couche d'électrode (37) forment une couche d'électrode de cadre (40) entourant au moins partiellement la région cloisonnée (50).

2. Cellule solaire selon la revendication 1, dans laquelle la couche d'électrode de cadre (40) a une forme annulaire ou une forme annulaire ouverte.

3. Cellule solaire selon la revendication 2, dans laquelle la couche d'électrode cadre (40) a au moins une partie de forme incurvée et au moins une partie de forme linéaire.

4. Cellule solaire selon l'une quelconque des revendications 1 à 3, dans laquelle au moins l'une parmi la couche d'électrode principale (27b) de la première couche d'électrode (27) et la couche d'électrode principale (37b) de la deuxième couche d'électrode (27) comprend une couche d'électrode principale sous forme de bande (27bb, 37bb) s'étendant depuis la couche d'électrode de cadre (40).

5. Cellule solaire selon la revendication 4, dans laquelle la couche d'électrode principale sous forme de bande (27bb) de la première couche d'électrode (27) et la couche d'électrode principale sous forme de bande (37bb) de la deuxième couche d'électrode (37) sont adjacentes l'une à l'autre.

6. Cellule solaire selon l'une quelconque des revendications 1 à 5, dans laquelle la couche d'électrode principale (27b, 37b) de la première couche d'électrode (27) ou de la deuxième couche d'électrode (37) comprend une couche d'électrode principale sous forme de bande (37bb) agencée à l'intérieur de la couche d'électrode de cadre (40).

7. Cellule solaire selon la revendication 6, dans laquelle la couche d'électrode principale sous forme de bande (27bb, 37bb) est couplée à la couche d'électrode de branche (27f) entourant le bord extérieur de la première région spécifique (60).

8. Cellule solaire selon l'une quelconque des revendications 1 à 7, comprenant une deuxième région spécifique (61) prévue au niveau de la surface principale et ne comprenant pas la première couche d'électrode (27) et la deuxième couche d'électrode (37), dans lequel
la couche d'électrode principale (27b) de la première couche d'électrode (27) comprend une couche d'électrode principale enveloppante (27be) renfermant un bord extérieur de la deuxième région spécifique (61), et une couche d'électrode principale sous forme de bande (27bb) s'étendant depuis la couche d'électrode principale enveloppante (27be).

9. Cellule solaire selon l'une quelconque des revendications 1 à 8, dans laquelle la première région spécifique (60) est un trou traversant ou présente un matériau de résistance plus élevée que la première couche d'électrode (27) et la deuxième couche d'électrode (37) .

10. Cellule solaire selon la revendication 8, dans laquelle la deuxième région spécifique (61) est un trou traversant ou présente un matériau de résistance plus élevée que celle de la première couche d'électrode (27) et de la deuxième couche d'électrode (37).

11. Cellule solaire selon l'une quelconque des revendications 1 à 10, dans laquelle, dans une région de la région cloisonnée (50) et à l'exception de la couche d'électrode principale (27b, 37b) et de la première région spécifique (60), la couche d'électrode de branche (27f, 37f) est formée pour être centrée sur le centre de la première région spécifique (60) et pour chevaucher une figure similaire de la première région spécifique (60).

12. Dispositif électronique comprenant la cellule solaire selon l'une quelconque des revendications 1 à 11.
